# FASCICULE DE BREVET EUROPEEN

(11) **EP 0 974 929 B1**
(45) Date de publication et mention de la délivrance du brevet: **09.04.2014**
(21) Numéro de dépôt: 99401779.6
(22) Date de dépôt: 15.07.1999
(51) Int. Cl.: G06K 19/077

(54) **Procédé de fabrication d'une carte à puce électronique et carte à puce électronique**
Chipkarte und Verfahren zu deren Herstellung
Chip card and method of manufacturing a chip card

(30) Priorité: 20.07.1998 FR 9809199
(43) Date de publication de la demande: 26.01.2000
(73) Titulaire: STMicroelectronics S.A., 92120 Montrouge (FR)
(72) Inventeur: Brechignac, Rémi, 38000 Grenoble (FR)
(74) Mandataire: Casalonga, Axel

(56) Documents cités:
- EP-A- 0 671 705
- EP-A- 0 706 152
- EP-A- 0 737 935
- DE-A- 4 431 605
- FR-A- 2 756 955

## Description

La présente invention concerne un procédé de fabrication d'une carte à puce électronique et une carte à puce électronique en particulier obtenue par ce procédé.

On fabrique et on utilise de plus en plus des cartes électroniques dites sans contact, c'est-à-dire des cartes en matière plastique qui renferment une antenne qui se présente sous la forme d'une spire métallique et un module électronique relié électriquement à cette antenne, ce module comprenant un boîtier support et de connexion renfermant une puce électronique.

Actuellement, pour la fabrication de telles cartes électroniques, on forme sur une face d'une feuille pleine en matière plastique une spire métallique et on pose sur cette feuille, en surépaisseur, un module électronique parallélipipédique en interposant entre les plots de connexion de ce module et les parties d'extrémité de la spire un matériau de soudure, on prend en sandwich cet ensemble entre deux feuilles de recouvrement en matière plastique et on lamine à chaud l'ensemble pour obtenir une carte. Dans une variante, le module électronique présente une partie qui s'étend dans un passage traversant de la feuille centrale et une collerette qui vient, en surépaisseur, au regard de cette feuille et qui présente des plots de connexion soudés à la spire.

On a pu constater que le laminage engendre des tensions dans les points de soudure et qu'après laminage il subsiste autour du module des poches non remplies de matière, ce qui fragilise les connexions électriques entre le module et la spire métallique, ces poches étant en outre susceptibles d'engendrer une rétention d'humidité détériorant le module, la spire métallique et leurs connexions électriques.

Pour éviter celà, on est obligé de remplir les interstices entre le module et la feuille centrale d'une résine fluide adaptée avant la prise en sandwich de la feuille centrale entre les deux feuilles de recouvrement et le laminage.

Les techniques ci-dessus de l'art antérieur obligent à l'utilisation de colles de soudage basse température de faible fiabilité, obligent à l'application d'une résine de remplissage pour s'affanchir des problèmes de contrainte après lamination des feuilles et d'humidité et conduisent à l'obtention de cartes relativement épaisses compte tenu de la surépaisseur induite par le module électronique. Un exemple de l'art antérieur est divulgué dans EP 0 706 152 A.

Le but de la présente invention est en particulier de réduire les inconvénients ci-dessus.

La présente invention a tout d'abord pour objet un procédé de fabrication d'une carte à puce électronique.

Ce procédé consiste, selon l'invention, à réaliser dans une feuille centrale un passage traversant et à munir au moins l'une des faces de cette feuille d'au moins une spire métallique présentant des parties de connexion passant devant ledit passage ; à engager dans ledit passage une puce électronique présentant sur sa face s'engageant la première dans ce passage des plots de connexion électrique et à souder respectivement ces plots auxdites parties de connexion de ladite spire ; et à munir les faces de ladite feuille centrale de feuilles extérieures de recouvrement ; de telle sorte que ladite spire et ladite puce sont noyées dans la carte ainsi constituée.

Selon l'invention, le procédé peut avantageusement consister à laminer ou presser à chaud l'empilage constitué par lesdites feuilles de telle sorte que le matériau les constituant flue de manière à remplir l'espace environnant ladite puce électronique notamment dans ledit passage.

La présente invention a également pour objet une carte à puce électronique, portant au moins une spire métallique qui présente au moins deux parties de connexion reliées à une puce électronique.

Cette carte à puce comprend, selon l'invention, une feuille centrale qui porte sur une de ses faces ladite spire métallique et qui présente un passage traversant devant lequel passent lesdites parties de connexion de ladite spire, que ladite puce électronique est engagée dans ledit passage et présente sur une de ses faces des plots de connexion électrique soudés auxdites parties de connexion de ladite spire et qu'elle comprend des feuilles extérieures de recouvrement prenant entré elles ladite feuille centrale au moins dans la zone dudit passage et de ladite spire.

Selon l'invention, ladite puce et au moins lesdites parties de connexion de ladite spire sont de préférence noyées dans le matérau constituant au moins l'une desdites feuilles.

La présente invention sera mieux comprise à l'étude des différentes étapes d'un procédé de fabrication d'une carte à puce électronique, décrites à titre d'exemples non limitatifs et illustrés par le dessin sur lequel :
- la figure 1 représente une vue d'une face d'une feuille centrale d'une carte à puce électronique selon la présente invention ;
- la figure 2 représente une vue d'une face d'une puce électronique à insérer ;
- la figure 3 représente une coupe partielle selon III-III de la feuille centrale de la figure 1, avec la puce à insérer en position de montage ;
- la figure 4 représente une coupe correspondant à celle de la figure 3, dans laquelle la puce électronique est montée ;
- la figure 5 représente une vue correspondant à celle de la figure 4, avec deux feuilles opposées de recouvrement en position de montage ;
- et la figure 6 représente une coupe correspondant à la figure 5, de la carte à puce électronique selon l'invention en fin de fabrication.

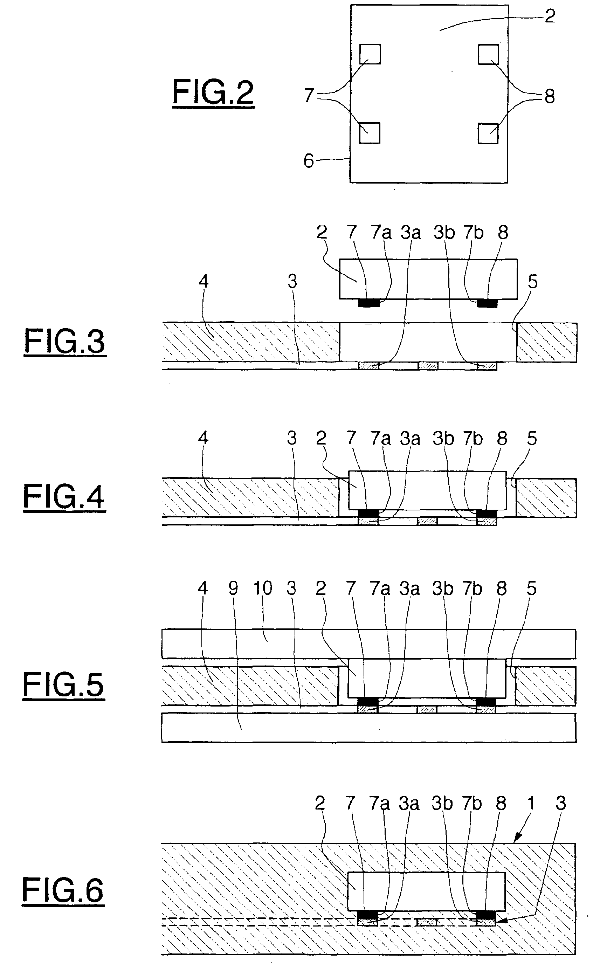

En se reportant à la figure 6, on voit qu'on a représenté une carte 1 qui renferme une puce électronique 2 disposée au voisinage d'un côté de cette carte et qui est électriquement reliée à une spire métallique 3 constituant une antenne qui s'étend au voisinage de la périphérie de la carte 1.

Pour la fabrication de cette carte 1 à puce électronique, on peut procéder de la manière suivante.

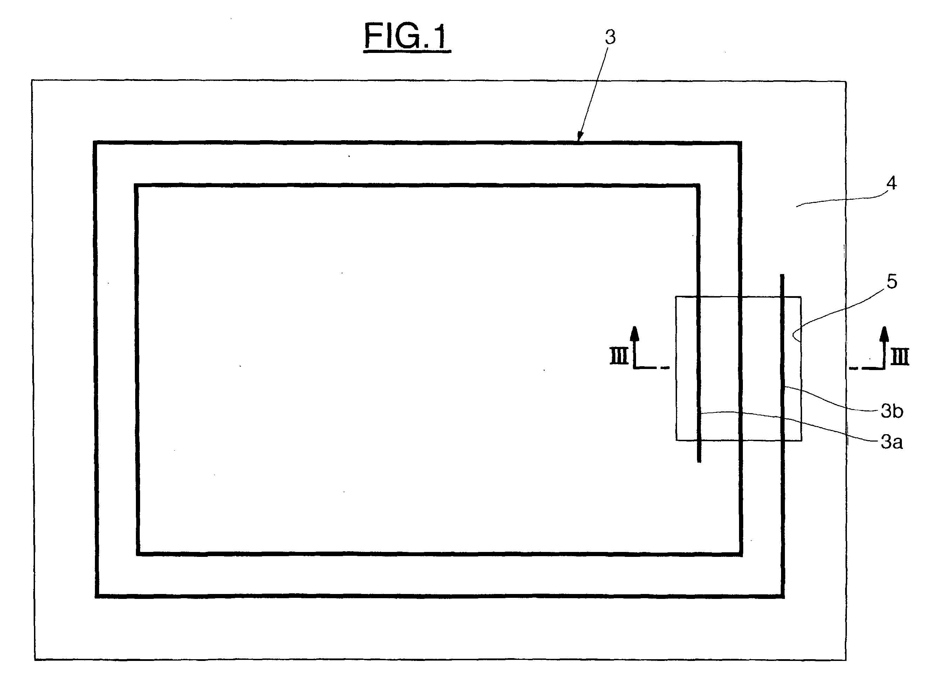

Comme le montre en particulier la figure 1, on prend une feuille 4 en matière plastique, par exemple en polychlorure de vinyl, sur une face de laquelle on réalise la spire métallique 3 et au travers de laquelle on réalise un passage traversant 5, de telle sorte que la spire 3 présente des parties libres de connexion 3a et 3b qui passent, parallèlement, devant ce passage 5 et qui sont à faible distance de ses extrémités. Dans l'exemple représenté, la spire 3 fait deux tours et est formée par une couche ou bande de cuivre déposée sur la feuille 4.

Comme le montre en particulier la figure 2, la puce électronique 2 qui est nue ou brute, c'est-à-dire non installée dans un boîtier de protection et de connexion, est de forme parallélipipédique et présente un pourtour 5 rectangulaire et présente, sur l'une de ses faces, des paires de plots 7 et 8.

La passage 5 de la feuille centrale 4 est dimensionné de manière à pouvoir recevoir la puce électronique 2, en ménageant un espace entre le pourtour 6 de cette dernière et les flancs du passage 5.

Comme le montre successivement les figures 3 et 4, après avoir déposé des gouttes 7a et 7b d'un matériau de soudure, par exemple de plomb-étain, sur les plots 7 et 8 de la puce 2, on insère la puce électronique 2 dans le passage 5 de la feuille centrale 4 en engageant en premier la face de cette dernière qui présente des plots 7 et 8 jusqu'à ce que les parties de connexion 3a et 3b de la spire 3 s'étendant devant la face de la puce électronique 2 présentant les plots de connexion 7 et 8 et respectivement devant ces plots de connexion, un espace régulier étant ménagé entre la périphérie 6 de la puce électronique 2 et les flancs du passage 5.

Puis, on soude à chaud les plots de connexion 7 et 8 sur parties de connexion 3a et 3b de la spire métallique 3 par l'intermédiaire des gouttes de matériau de soudure 7a et 7b.

Comme le montre en particulier la figure 5, on place ensuite, sur les faces opposées de la feuille centrale 4, des feuilles 9 et 10 de recouvrement en matière plastique, par exemple en polychlorure de vinyl.

Après quoi, on procède de façon connue en soi à un laminage ou un pressage à chaud de l'empilage ainsi constitué par la feuille centrale 4 et les feuilles de recouvrement 9 et 10, de manière à obtenir la carte à puce électronique 1 telle que réprésentée sur la figure 6 et décrite précédemment.

Lors de ce laminage ou pressage, les feuilles 4, 9 et 10 fluent et remplissent complètement l'espace environnant la puce électronique 2 et la spire métallique 3, notamment dans le passage 5, de façon à ne laisser subsister aucun interstice exempt de matériau.

En fait, comme le montre la figure 6, après laminage ou pressage, la feuille centrale 4 et les feuilles de recouvrement 9 et 10 constituent un seul bloc dans lequel sont complètement noyées la puce électronique 2 et la spire métallique 3.

La puce 2 étant insérée dans le passage 5 de la feuille centrale 4 et ne présentant donc aucune partie en regard des faces de cette feuille centrale 4 et les parties de connexion 3a et 3b de la spire métallique 3 s'étendant directement devant une face de la puce électronique 2, celà permet d'obtenir une carte à puce électronique 1 d'épaisseur réduite, robuste notamment dans la zone des connexions électriques entre les plots 7 et 8 et les parties de connexion 3a et 3b et protégées vis-à-vis de l'humidité notamment du fait de l'absence d'interstices autour de la puce électronique 2 et de la spire métallique 3.

## Revendications

1. Procédé de fabrication d'une carte à puce électronique, **caractérisé par le fait qu'**il consiste : à réaliser dans une feuille centrale (4) un passage traversant (5) et à munir au moins l'une des faces de cette feuille d'au moins une spire métallique (3) présentant des parties de connexion (3 a, 3b) passant devant ledit passage (5) ; à engager dans ledit passage une puce électronique (2) présentant sur sa face s'engageant la première dans ce passage des plots de connexion électrique (7, 8) et à souder respectivement ces plots auxdites parties de connexion de ladite spire ; et à munir les faces de ladite feuille centrale (4) de feuilles extérieures de recouvrement (9, 10) ; de telle sorte que ladite spire (3) et ladite puce (2) sont noyées dans la carte ainsi constituée.

2. Procédé selon la revendication 1, **caractérisé par le fait qu'**il consiste : à laminer ou presser à chaud l'empilage constitué par lesdites feuilles (4, 9, 10) de telle sorte que le matériau les constituant flue de manière à remplir l'espace environnant ladite puce électronique notamment dans ledit passage.

3. Carte à puce électronique, portant au moins une spire métallique qui présente au moins deux parties de connexion reliées à une puce électronique, obtenue par le procédé selon l'une des revendications 1 et 2, **caractérisée par le fait qu'**elle comprend une feuille centrale (4) qui porte sur une de ses faces ladite spire métallique (3) et qui présente un passage traversant (5) devant lequel passent lesdites parties de connexion (3a, 3b) de ladite spire, que ladite puce électronique (2) est engagée dans ledit passage en ménageant un espace entre le pourtour (6) de ladite puce et les flancs dudit passage (5) et présente sur une de ses faces des plots de connexion électrique soudés auxdites parties de connexion de ladite spire et qu'elle comprend des feuilles extérieures de recouvrement (9, 10) prenant entre elles ladite feuille centrale (4) et remplissant ledit espace, ladite puce et au moins lesdites parties de connexion de ladite spire étant noyées dans le matériau constituant au moins l'une desdites feuilles.

## Patentansprüche

1. Verfahren zur Herstellung einer elektronischen Chipkarte, **dadurch gekennzeichnet, dass** es aus Folgendem besteht: Ausführen eines Durchlasses (5) in einer mittleren Folie (4) und Versehen von mindestens einer der Seiten dieser Folie mit mindestens einer Metallwindung (3), die Verbindungsteile (3a, 3b) aufweist, die vor dem Durchlass (5) verlaufen; Einführen eines elektronischen Chips (2) in den Durchlass, der auf seiner Fläche, die zuerst in diesen Durchlass eingeführt wird, elektrische Verbindungskontakte (7, 8) aufweist, und Löten dieser Kontakte jeweils an die Verbindungsteile der Windung; und Versehen der Seiten der mittleren Folie (4) mit äußeren Deckfolien (9, 10); derart, dass die Windung (3) und der Chip (2) in der so gebildeten Karte versenkt sind.

2. Verfahren nach Anspruch 1, **dadurch gekennzeichnet, dass** es aus Folgendem besteht: Warmwalzen oder -pressen des durch die Folien (4, 9, 10) gebildeten Stapels, derart, dass das Material, aus dem sie bestehen, so fließt, dass der Raum, der den elektronischen Chip umgibt, insbesondere in dem Durchlass, gefüllt wird.

3. Elektronische Chipkarte, die mindestens eine Metallwindung trägt, die mindestens zwei Verbindungsteile aufweist, die mit einem elektronischen Chip verbunden sind, die durch das Verfahren nach einem der Ansprüche 1 und 2 erhalten wird, **dadurch gekennzeichnet, dass** sie eine mittlere Folie (4) aufweist, die auf einer ihrer Seiten die Metallwindung (3) trägt und die einen Durchgang (5) aufweist, vor dem die Verbindungsteile (3a, 3b) der Windung verlaufen, dass der elektronische Chip (2) in den Durchgang eingeführt ist, indem ein Raum zwischen dem äußeren Umfang (6) des Chips und den Flanken des Durchgangs (5) vorgesehen ist, und auf einer seiner Seiten elektrische Verbindungskontakte aufweist, die an die Verbindungsteile der Windung gelötet sind, und dass sie äußere Deckfolien (9, 10) aufweist, die zwischen sich die mittlere Folie (4) einkeilen und den Raum füllen, wobei der Chip und mindestens die Verbindungsteile der Windung in dem Material versenkt sind, das wenigstens die eine der Folien bildet.

## Claims

1. Process for manufacturing a smart card, **characterized in that** it consists: in producing a through-passage (5) in a central sheet (4) and in providing at least one of the faces of this sheet with at least one metal coil (3) having connection parts (3a, 3b) that go past the said passage (5); in inserting an electronic chip (2) into the said passage, the said chip having electrical connection pads (7, 8) on its face which enters this passage first, and in soldering these pads to the said connection parts of the said coil, respectively; and in providing the faces of the said central sheet (4) with external covering sheets (9, 10) in such a way that the said coil (3) and the said chip (2) are embedded in the card thus formed.

2. Process according to Claim 1, **characterized in that** it consists: in hot pressing or laminating the stack formed by the said sheets (4, 9, 10) in such a way that the material of which they are formed flows so as to fill the space surrounding the said electronic chip, especially into the said passage.

3. Smart card, bearing at least one metal coil which has at least two connection parts connected to an electronic chip, obtained by the process according to either of Claims 1, and 2, and **characterized in that** it comprises a central sheet (4) which bears, on one of its faces, the said metal coil (3), and which has a through-passage (5) past which the said connection parts (3a, 3b) of the said coil go, **in that** the said electronic chip (2) is inserted into the said passage, leaving a space between the perimeter (6) of the said chip and the side walls of the said passage (5), and has, on one of its faces, electrical connection pads soldered to the said connection parts of the said coil, and **in that** it comprises external covering sheets (9, 10) which grip between them the said central sheet (4) and fill the said space, the said chip and at least the said connection parts of the said coil being embedded in the material forming at least one of the said sheets.
